(19) Europäisches Patentamt / European Patent Office / Office européen des brevets

(11) **EP 1 913 406 B1**

(12) **FASCICULE DE BREVET EUROPEEN**

(45) Date de publication et mention de la délivrance du brevet:
**27.01.2010 Bulletin 2010/04**

(21) Numéro de dépôt: **06779943.7**

(22) Date de dépôt: **28.07.2006**

(51) Int Cl.:
*G01R 15/20* *(2006.01)*

(86) Numéro de dépôt international:
**PCT/IB2006/002163**

(87) Numéro de publication internationale:
**WO 2007/020500 (22.02.2007 Gazette 2007/08)**

(54) **CAPTEUR DE COURANT TRIPHASE**

DREIPHASENSTROMSENSOR

THREE-PHASE CURRENT SENSOR

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **12.08.2005 EP 05405475**

(43) Date de publication de la demande:
**23.04.2008 Bulletin 2008/17**

(73) Titulaire: **LIAISONS ELECTRONIQUES-MECANIQUES LEM S.A.
1228 Plan-les-Ouates (CH)**

(72) Inventeurs:
• **LEPINE, Gérard**
  **F-74250 Peillonnex (FR)**
• **LABBE, Arnaud**
  **F-74160 Saint-Julien-en-Genevois (FR)**
• **VO, Vinh, Tho**
  **CH-1217 Meyrin (CH)**

(74) Mandataire: **Reuteler, Raymond Werner
Reuteler & Cie SA
Chemin de la Vuarpillière 29
1260 Nyon (CH)**

(56) Documents cités:
EP-A- 0 597 404    WO-A-94/27157
DE-C1- 4 215 900   GB-A- 825 137

EP 1 913 406 B1

**Description**

La présente invention concerne un capteur pour la mesure de courants électriques dans un système de conduction électrique à trois phases.

La présente invention est surtout destinée à la mesure de courants triphasés de grande amplitude.

Il y a de nombreuses applications où des capteurs de courant triphasé sont utilisés dans le domaine industriel, entre autres pour la commande ou le contrôle de moteurs triphasés. Typiquement, dans les systèmes triphasés, l'on place autour de chacun des trois conducteurs un capteur de courant comprenant un circuit magnétique en un matériau magnétique doux, souvent laminé, ayant un entrefer dans lequel est disposé un capteur de champ magnétique. Un capteur de champ magnétique très répandu est un capteur à effet Hall, intégré dans un ASIC ayant des bornes pour sa connexion à un circuit imprimé pour le traitement des signaux. L'on peut mesurer le courant électrique et en déduire la puissance électrique en disposant des capteurs autour de deux des trois phases dans l'hypothèse où la somme des courants est nulle. Néanmoins, si l'on veut aussi détecter des éventuels courants de fuite, notamment pour des raisons de sécurité, il est nécessaire de mesurer le courant électrique dans les trois phases et on disposera alors des capteurs autour de chacune des phases.

La mesure de courant élevé pose des problèmes dans les capteurs existants et nécessite des mesures spéciales, encombrantes et coûteuses. Les courants élevés génèrent des champs magnétiques élevés pouvant saturer le circuit magnétique du capteur, entraînant une réponse non-linéaire et, par conséquent, des erreurs de mesure. Ce problème de saturation est aggravé quand les conducteurs des trois phases sont rapprochés, puisque le champ magnétique des conducteurs adjacents s'ajoute au champ généré par le conducteur autour duquel le capteur en question est disposé.

Afin d'éviter la saturation du circuit magnétique, on peut augmenter la section du circuit magnétique. Dans beaucoup d'applications (par exemple dans le domaine automobile), on cherche toutefois à réduire l'encombrement et le poids des appareils de mesure. Une des applications futures de capteurs de courant se trouve justement dans le domaine de la commande des systèmes d'alimentation électrique des véhicules à moteur électrique où les courants peuvent être très élevés en raison de la tension relativement faible et des puissances élevées nécessaires pour la propulsion du véhicule. L'augmentation de la section des circuits magnétiques augmente également le coût du capteur.

Une autre solution qui a été considérée est de placer au moins un des capteurs de champ magnétique dans une encoche formée dans un des conducteurs portant les trois phases afin de réduire le nombre de circuits magnétiques et de limiter les problèmes de saturation de ses circuits. Toutefois, la réalisation d'une encoche dans un des conducteurs et le montage d'un capteur champ magnétique dans cette encoche est une solution coûteuse. En plus, on n'a toujours pas résolu le problème de l'influence des champs magnétiques générés par les conducteurs voisins de courant fort, ce qui limite les possibilités de réduire l'encombrement du dispositif de mesure.

WO 94 27 157 (ABB STROMBERG) divulgue un capteur de courant comprenant un dispositif de mesure magnétique avec circuit magnetic par phase. GB 825 137 (SIEMENS) divulgue un capteur de courant avec circuit magnetique avec deux entrefers.

Un but de l'invention est de fournir un capteur de courant triphasé, compact et peu onéreux, cela notamment pour la mesure de courant élevé. Par "courant élevé", on entend des courants élevés tenant compte des distances séparant les trois phases et l'encombrement du capteur.

Il est avantageux de fournir un capteur de courant triphasé qui peut facilement être installé et connecté dans un système de conduction à trois phases, tel que le système d'alimentation d'un moteur électrique triphasé.

Il est avantageux de fournir un capteur de courant triphasé qui est peu sensible aux champs externes, par exemple produits par des conducteurs électriques disposés à proximité du capteur.

Il est avantageux de fournir un capteur de courant triphasé qui permet une bonne précision de mesure de courant électrique sur une grande plage d'amplitude du courant.

Des buts de l'invention sont réalisés par le capteur de courant selon la revendication 1 et un procédé de mesure de courants selon la revendication 9.

Dans la présente demande, on décrit un capteur de courant triphasé pour la mesure de courants circulant dans un système de conduction à trois phases, comprenant un premier dispositif de mesure magnétique et un deuxième dispositif de mesure magnétique, chaque dispositif de mesure magnétique comprenant un circuit magnétique comprenant au moins deux entrefers, et un détecteur de champ magnétique disposé dans chaque entrefer du circuit magnétique. Les dispositifs de mesure magnétique sont disposés de part et d'autre d'une partie de conducteur central, ou d'une cavité pour l'insertion d'un conducteur central formant l'une des trois phases du système de conduction.

De préférence, lesdits au moins deux entrefers de chaque circuit magnétique des dispositifs de mesure magnétique sont disposés essentiellement dans un même plan.

De préférence, des axes de trois parties de conducteur traversant le capteur, ou des axes des trois cavités pour l'insertion des trois conducteurs, sont essentiellement parallèles et disposés dans ledit plan des entrefers.

De préférence, les détecteurs de champ magnétique disposés dans les entrefers sont des capteurs à effet Hall réalisés sous forme d'ASIC's.

Dans la forme d'exécution préférée, il y a deux circuits magnétiques et deux entrefers dans chaque circuit magnétique, les entrefers étant alignés dans un même plan avec des parties de conducteurs primaires traversant le capteur, ou avec les axes des cavités pour l'insertion des conducteurs primaires traversant le capteur, les deux circuits magnétiques étant disposés de part et d'autre d'un conducteur d'une des phases ou d'une cavité pour l'insertion d'un conducteur d'une des phases. Le conducteur primaire centrale n'a donc aucun dispositif de mesure magnétique.

De préférence, les dispositifs de mesure magnétique sont montés sur une plaque de support commune. Cette plaque de support peut constituer une paroi formant partie du boîtier du capteur dans lequel les circuits magnétiques sont montés. La plaque de support peut aussi comprendre un circuit avec une électronique pour le traitement des signaux.

Dans la présente demande, on décrit aussi un procédé de mesure de courants circulant dans un système de conduction à trois phases au moyen d'un capteur de courant comprenant un premier dispositif de mesure magnétique et un deuxième dispositif de mesure magnétique, le procédé comprenant :

- la mesure du courant circulant dans une première des trois phases à partir de la mesure du champ magnétique généré par ledit courant de cette première phase par le premier dispositif magnétique,
- la mesure du courant circulant dans une troisième des trois phases à partir de la mesure du champ magnétique généré par ledit courant de cette troisième phase par le deuxième dispositif magnétique, et
- la mesure du courant d'une deuxième des trois phases à partir de l'influence du champ magnétique généré par le courant de cette deuxième phase sur les premier et deuxième dispositifs magnétiques.

D'autres aspects avantageux et buts de l'invention ressortiront des revendications, de la description détaillée de formes d'exécution ci-après et des dessins annexés, dans lesquels:

la Fig. 1a est une vue en perspective d'un capteur de courant triphasé selon une première forme d'exécution de l'invention;

la Fig. 1b est une vue en perspective du capteur de la Fig. 1a sans boîtier;

les Figures 2a et 2b sont des vues en perspective d'un capteur de courant triphasé selon une deuxième forme d'exécution de l'invention;

la Fig. 2c est une vue en perspective d'une partie du capteur de courant des Figures 2a et 2b, sans boîtier;

la Fig. 3 est une illustration simplifiée du capteur de courant selon l'invention pour expliquer son principe de fonctionnement; et

les Figures 4a à 4c sont des schémas simplifiés d'une partie du capteur de courant selon l'invention, utilisés pour expliquer son principe de fonctionnement.

Faisant référence aux figures, un capteur de courant 1 pour la mesure du courant électrique circulant dans trois conducteurs Ph1, Ph2, Ph3 correspondant à trois phases d'un système de conduction - c'est-à-dire d'alimentation ou de génération énergie électrique - comprend des dispositifs de détection du champ magnétique D1, D3, un boîtier 4 et un support 5. Le support 5 peut former une des parois externes du boîtier 4. Dans une autre forme d'exécution, le support 5 comprend une plaquette de circuit, tel qu'un circuit imprimé, sur lequel on peut disposer des composants électroniques pour le traitement des signaux de mesure ou encore pour d'autres fonctions de commande et de contrôle du capteur et/ou de transmission de données à des unités d'affichage ou de commande du moteur. A cet effet, on peut fournir des bornes électriques 6 montées sur la plaquette de circuit, ou simplement connectées aux dispositifs de détection magnétique, pour permettre l'interconnexion du circuit à une électronique externe.

Les dispositifs de mesure du champ magnétique D1, D3 comprennent un circuit magnétique M ayant au moins deux parties de circuit M1, M2, M3, M4 séparées par entrefers E1, E2, E3, E4 et des détecteurs de champ magnétiques C1, C2, C3, C4 disposés dans chaque entrefer E1, E2, E3, E4. Les détecteurs de champs magnétiques sont de préférence des capteurs à effet Hall incorporés dans un ASIC et munis de bornes de connexion 7. Les capteurs à effet Hall sont bien connus et il n'y a donc pas lieu de les décrire ici.

D'autres détecteurs de champs magnétiques peuvent également être utilisés au lieu des détecteurs à effet Hall.

Les circuits magnétiques M peuvent être formés de feuilles de matériaux doux empilées, ayant une forme essentiellement annulaire comme illustrée, mais pourrait avoir également d'autres formes telles que carrée, rectangulaire, polygonale. Les dispositifs de mesure de champ magnétique D1, D3 sont montés aux extrémités du capteur, pour entourer les conducteurs Ph1, Ph3 disposés de part et d'autre du conducteur central Ph2. Les trois conducteurs portant les trois phases sont donc disposés de manière essentiellement parallèle dans un même plan à l'endroit où ils traversent le capteur.

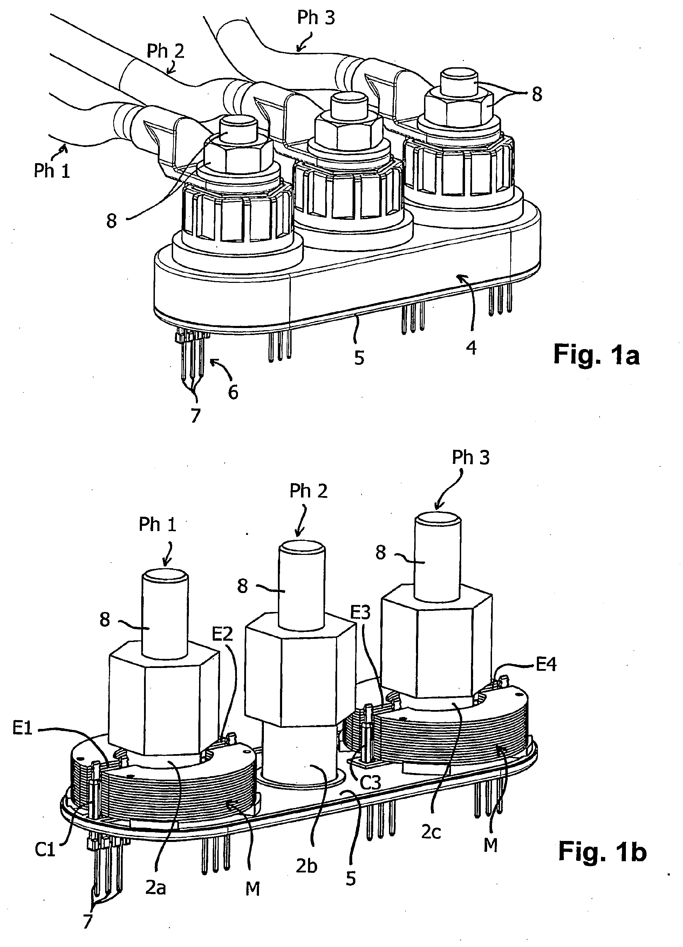

Dans une première forme d'exécution (Figures 1a, 1b), des parties de conducteur 2a, 2b, 2c traversant le capteur, peuvent être intégrées directement dans le capteur et comprennent des bornes 8 pour la connexion des trois conducteurs Ph1, Ph2, Ph3.

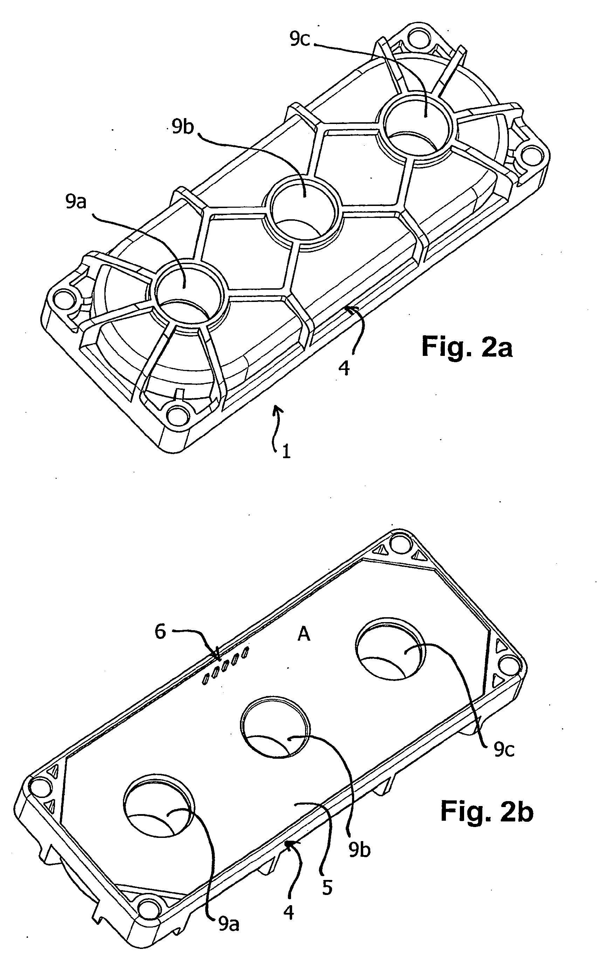

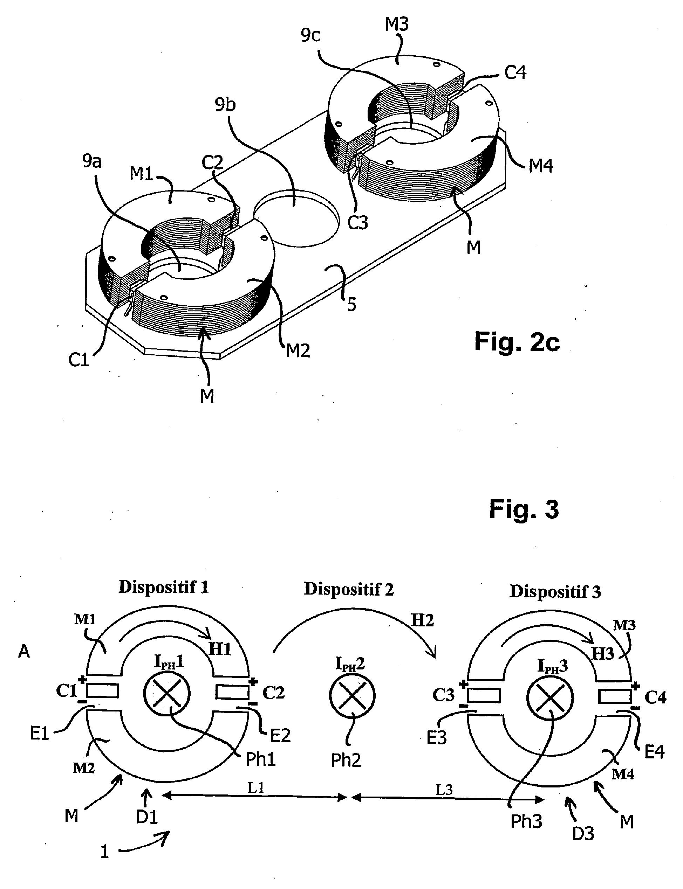

Dans une autre forme d'exécution montrée dans les figures 2a à 2c, le capteur peut être muni de passages 9a, 9b, 9c dans lesquels les trois conducteurs externes sont insérés pour traverser le capteur. Dans cette forme d'exécution, l'on pourrait également former le capteur en deux parties, séparées par l'axe/le plan médiane A, pour pouvoir monter le capteur autour des trois conducteurs sans devoir enfiler les conducteurs ou les interrompre. Comme les circuits magnétiques M ont chacun deux entrefers E1, E2, E3, E4, qui sont disposés dans le même plan d'alignement A des trois conducteurs primaires 2a, 2b, 2c, la réalisation d'un capteur en deux parties est facilitée.

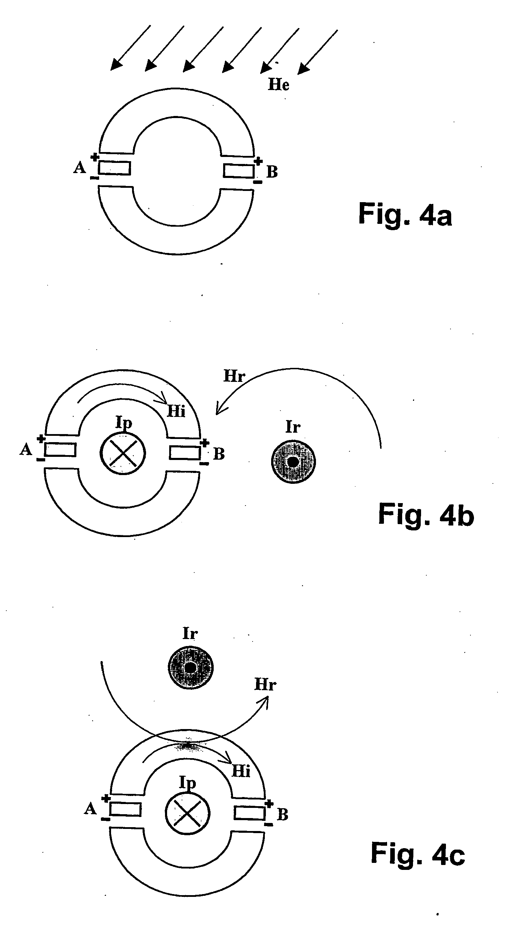

Faisant référence aux Figures 3 et 4a à 4c, nous expliquerons maintenant le principe de fonctionnement du capteur selon l'invention.

Faisant référence à la Fig. 3, le capteur triphasé regroupe trois phases de courants à mesurer $I_{PH}1$, $I_{PH}2$, $I_{PH}3$ et les dispositifs de mesure magnétique D1, D3. Dans certaines applications, les dimensions mécaniques doivent être réduites pour tenir compte des exigences de miniaturisation. Cela pose le problème des perturbations magnétiques (proximité des barres de courant les une par rapport aux autres) qui peuvent produire des erreurs de mesure très importantes.

Dans l'invention, l'on utilise ces perturbations magnétiques comme des éléments participant à l'élaboration de la mesure et non comme des éléments perturbateurs.

De préférence, les trois phases de courant $I_{PH}1$, $I_{PH}2$, $I_{PH}3$ circulent dans des parties de conducteur 2a, 2b, 2c (phases Ph1, Ph2, Ph3) et sont positionnées sur un même plan. Les distances (L1, L3) entre les phases Ph1 et Ph2, Ph2 et Ph3, peuvent être de valeur quelconque, mais de préférence, pour la simplification des algorithmes, L1 = L3. Il est aussi souhaitable que L1 et L3 soient d'une grandeur suffisamment petite pour bénéficier de l'avantage du système.

Les éléments de mesure comprennent quatre cellules de Hall C1, C2, C3, C4 de mesure d'induction et quatre parties de circuits magnétiques M1, M2, M3, M4 de concentration de champs magnétique. Les cellules de Hall et les entrefers E1, E2, E3, E4 formés.par les circuits magnétiques sont positionnés sur le même axe/plan A que les barres de courant 2a à 2c.

Le premier dispositif de mesure magnétique D1 permet la mesure du courant de la première phase $I_{PH}1$. Il comprend la phase Ph1 (bus barre), deux cellules de Hall (cellule C1, cellule C2) et deux parties de circuits magnétiques (M1, M2) séparées par les entrefers E1, E2.

Le dispositif de mesure magnétique D3 permet la mesure du courant de la troisième phase $I_{PH}3$. Il comprend la phase Ph3 (bus barre), deux cellules de Hall (cellule C3, cellule C4) et deux parties de circuits magnétiques (M3, M4) séparées par les entrefers E3, E4.

Il n'y a pas de dispositif de mesure magnétique autour de la phase Ph2. Il comprend la phase $I_{PH}2$ (bus barre). Les dispositifs de mesure magnétique D1, D3 sont utilisés pour constituer la mesure du courant de la deuxième phase $I_{PH}2$.

Dans la Fig. 3, on suppose que le sens du courant dans les phases est positif lorsque le courant entre dans le dispositif (représenté par une croix). Dans ces conditions les champs magnétiques H1, H2, H3 circulent dans le sens horaire.

Les signaux de sortie fournis par le système sont définis par une grandeur qui représente l'image du courant qui circule dans les phases de courant. Ces signaux S1, S2, S3 peuvent des signaux électriques continus par exemple une tension ou un courant, un signal numérique par exemple un protocole de liaison série filaire ou radiofréquence. Tout type de liaison de transmission peut être utilisé.

S1 = le signal de sortie du système qui représente l'image de $I_{PH}1$

S2 = le signal de sortie du système qui représente l'image de $I_{PH}2$

S3 = le signal de sortie du système qui représente l'image de $I_{PH}3$

Pour faciliter la démonstration nous supposons que les cellules de Hall C1, C2, C2, C4 ont été calibrées « in situ » pour que la sensibilité des quatre éléments soit identique. Les signaux fournis par les cellules de Hall sont positifs pour une induction du haut vers le bas sur la figure 3. Dans les relations qui suivent, nous considérons que:

C1 = signal de la cellule de hall C1

C2 = signal de la cellule de hall C2

C3 = signal de la cellule de hall C3

C4 = signal de la cellule de hall C4

Les phases Ph1 et Ph3 sont caractérisés par les relations suivantes:

$$S1 = S(I_{PH}1) = (C2-C1)*K1$$

où **K1** = sensibilité (gain) du dispositif de mesure magnétique D1

$$S3 = S(I_{PH}3) = (C4-C3)*K3$$

où **K3** = sensibilité (gain) du dispositif de mesure D2

Les coefficients K1 et K3 sont les rapports de transformation à appliquer sur les signaux des cellules de Hall pour obtenir la grandeur physique du signal S(x) de sortie. Dans l'hypothèse retenue de dispositif ayant des sensibilités identiques, nous pouvons écrire :

$$K1 = K3 = K$$

Les relations S1 et S3 deviennent :

$$S1 = S(I_{PH}1) = (C2-C1)*K$$

$$S3 = S(I_{PH}3) = (C4-C3)*K$$

où **K** = sensibilité (gain) des dispositifs D1 et D3

Le système offre la possibilité de calculer le signal S2 à l'aide des dispositifs D1, D3 de mesure magnétique sans ajouter de dispositif de mesure magnétique central. La mesure de $I_{PH}2$ peut avantageusement être calculée suivant la relation suivante :

$$S2 = S(I_{PH}2) = (C4+C3)*K23 - (C2+C1)*K21$$

où **k21** = Sensibilité (gain) de l'influence du courant de la phase 2 sur le dispositif magnétique de phase 1
**k23** = Sensibilité (gain) de l'influence du courant de la phase 2 sur le dispositif magnétique de phase 3

Les coefficients K21 et K23 sont les rapports de transformation à appliquer sur les signaux des cellules de Hall pour obtenir la grandeur physique du signal S($I_{PH}2$) de sortie. Dans l'hypothèse retenue de dispositif ayant des sensibilités identiques, nous pouvons écrire :

$$K21 = K23 = K2$$

$$S2 = S(I_{PH}2) = (C4 + C3 - C2 - C1)*K2 \,,$$

où
**k2** = Sensibilité (gain) de l'influence du courant la phase 2 sur les dispositifs magnétiques des phases 1 et 3

Les relations ci-dessus sont valables dans les conditions suivantes :

- Les trois phases de courant $I_{PH}1$, $I_{PH}2$, $I_{PH}3$ sont positionnées sur un même plan et les axes sur une ligne droite
- Les distances entre les phases sont égales (l1 =l3)

- Les parties de circuits magnétiques M1, M2, M3, M4 sont de formes identiques et disposées autour des phases Ph1 et Ph3 de manière symétrique
- Les entrefers magnétiques qui séparent les circuits magnétiques sont identiques (E1=E2=E3=E4)
- Les éléments de mesure magnétique (cellule de Hall) sont calibrés *in situ* de manière à ce que la sensibilité de chaque élément soit de valeur connue est identique $S_{C1} = S_{C2} = S_{C3} = S_{C4}$.

Cette calibration corrige toutes les erreurs dimensionnelles, de positionnement, de symétrie et de sensibilité de tous les éléments des dispositifs de mesure magnétique D1 et D3.

Ces dispositions permettent de simplifier les calculs des signaux S1, S2 et S3 de manière à ne conserver que un seul coefficient de gain K2 pour S2 et un coefficient de gain K pour S1 et S3.

D'autres dispositions des dispositifs de mesure magnétique, par exemple où les trois phases ne se trouvent pas sur le même axe/plan, sont possibles et permettront de calculer les signaux de sortie des trois phases. Dans ce cas il faudrait toutefois utiliser plus de coefficients de sensibilité pour obtenir un résultat avec précision.

Dans la démonstration ci-dessus, nous avons pris comme hypothèse l'utilisation de barres de courant primaire infini, et donc sans l'effet des champs magnétiques des retours de courant des circuits de puissance. L'intégration du capteur dans le sous-ensemble de puissance peut introduire des erreurs pour le calcul des signaux de sortie S2, ce qui n'aurait une influence que sur la précision de calcul des courants de fuite.

Le cheminement des circuits de puissance étant connu et maîtrisé, il est possible d'intégrer les perturbations magnétiques des courants de retour dans le calcul des coefficients de sensibilité. Le système de calibration du capteur devra tenir compte de cet environnement magnétique pour ajuster la sensibilité de chaque cellule de Hall pour obtenir les coefficients K de sensibilité désiré.

Dans le cas de perturbations magnétiques symétriques sur les dispositifs de mesure D1 et D3, les coefficients simplifiés K et K2 sont suffisant pour calculer les signaux de sortie. Si les perturbations magnétiques sont asymétriques alors il faudra introduire des coefficients multiples (K21, K23)

En résumé, les relations ci-dessus permettent de calculer les courants des trois phases avec deux dispositifs de mesure magnétique D1 et D3. La construction des dispositifs de mesure magnétique permet d'obtenir une excellente précision de mesure sur les phases Ph1 et Ph3 malgré la proximité de la phase centrale Ph2.

La mesure de la phase centrale Ph2 est assurée avec une bonne précision en l'absence de champ magnétique perturbateur non contrôlé. Dans ce cas nous pouvons prendre en compte le signal S2 pour la mesure de $I_{PH}2$.

En cas de champ magnétique perturbateur intense et non contrôlé par le système de mesure des erreurs de mesure $I_{PH}2$ apparaissent. Si la précision de mesure de $I_{PH}2$ n'est pas suffisante, nous pouvons appliquer la relation suivante :

$$S2 = - (S1+S3)$$

Dans ce cas, le signal S2 peut être avantageusement utilisé pour vérifier la relation

$$I_{PH}1 +\ I_{PH}2 + I_{PH}3 = 0$$

Ceci permet de détecter des courants de fuite avec suffisamment de précision et d'enclencher une procédure de fonctionnement en mode dégradé.

Le système offre suffisamment de redondance pour réaliser la mesure avec un nombre limité de cellules de Hall, puis de gérer des modes dégradés.

Le déclenchement d'un fonctionnement en mode dégradé peut être effectué si une des quatre cellules C1, C2, C3, C4 de mesure de champ magnétique est défectueuse. En principe lors qu'une cellule à effet Hall est défectueuse, elle ne délivre plus de signal en sortie. Ceci est facilement détectable dans les systèmes de régulation de moteur triphasé. En effet, le calculateur de régulation pilote le courant dans les phases et s'attend à lire des variations des signaux de sortie des cellules de Hall. En l'absence de variation du signal d'une cellule, le calculateur peut déclarer la cellule comme non fonctionnelle et déclencher un fonctionnement en mode dégradé.

Le mode dégradé va prendre en compte les trois cellules encore fonctionnelles et calculer les signaux S1, S2 et S3 suivant une nouvelle formulation. Il y a quatre modes de fonctionnement dégradé différent en fonction de la cellule de Hall en défaut :

Défaillance de C1 :

$$S1 = S(I_{PH}1) = C2*K11 + (C4+C3)*K111$$

**K11** = sensibilité de S1 // défaillance de C1
**K111** = coefficient de correction de S1 // défaillance de C1

$$S3 = S(I_{PH}3) = (C4-C3)*K31$$

**K31** = sensibilité de S3 // défaillance de C1

$$S2 = S(I_{PH}2) = (C3-C2)*K21$$

**K21** = coefficient de correction de S2 // défaillance de C1

Défaillance de C2 :

$$S1 = S(I_{PH}1) = C1*K12 + (C4+C3)*K121$$

**K12** = sensibilité de S1 // défaillance de C2
**K121** = coefficient de correction de S1 // défaillance de C2

$$S3 = S(I_{PH}3) = (C4-C3)*K32$$

**K32** = sensibilité de S3 // défaillance de C2

$$S2 = S(I_{PH}2) = (C4-C1)*K22 .$$

**K22** = coefficient de correction de S2 // défaillance de C2

Défaillance de C3 :

$$S1 = S(I_{PH}1) = (C2-C1)*K13$$

**K13** = sensibilité de S1 // défaillance de C3

$$S3 = S(I_{PH}3) = C4*K33 + (C1+C2)*K331$$

**K33** = sensibilité de S3 // défaillance de C3
**K331** = coefficient de correction de S3 // défaillance de C3

$$S2 = S(I_{PH}2) = (C4-C1)*K23$$

**K23** = sensibilité de S2 // défaillance de C3

Défaillance de C4 :

$$S1 = S(I_{PH}1) = (C2-C1)*K14$$

**K14** = sensibilité de S1 // défaillance de C4

$$S3 = S(I_{PH}3) = C3*K34 + (C1+C2)*K341$$

**K34** = sensibilité de S3 // défaillance de C4
**K341** = coefficient de correction de S3 // défaillance de C4
**S2 = S(I_{PH}2) = (C3-C2)*K24**
**K24** = coefficient de correction de S2 // défaillance de C4
Les paramètres influents étant choisis précédemment (égalité et symétrie), nous pouvons simplifier les relations :
X1 = K11 = - K34
X2 = K111 = K341
X3=K12=K33
X4 = K121 = - K331
X5 = K21 = K24
X6 = K22 = K23
X7 = K13 = K14 = K31 = K32
Et les relations simplifiées deviennent :

        Signal S1 :
        Défaillance de C1 :

$$S1 = S(I_{PH}1) = C2*X1 + (C4+C3)*X2 \ .$$

        Défaillance de C2 :

$$S1 = S(I_{PH}1) = C2*X3 + (C4+C3)*X4 \ .$$

        Défaillance de C3 ou C4 :

$$S1 = S(I_{PH}1) = (C2-C1)*X7 \ .$$

        Signal S2 :
        Défaillance de C1 ou C4 :

$$S2 = S(I_{PH}2) = (C4-C1)*X5 \ .$$

        Défaillance de C2 ou C3 :

$$S2 = S(I_{PH}2) = (C4-C1)*X6 \ .$$

(suite)

Signal S3 :
Défaillance de C1 ou C2 :

$$S3 = S(I_{PH}3) = (C4-C3)*X7.$$

Défaillance de C3 :

$$S3 = S(I_{PH}3) = C4*X3 - (C1+C2)*X4.$$

Défaillance de C4 :

$$S3 = S(I_{PH}3) = (C1+C2)*X2 - C3*X1.$$

Le mode dégradé permet de maintenir le fonctionnement du capteur si une au plus des quatre cellules n'est pas opérationnelle. Les performances du capteur sont moins bonnes notamment pour ce qui concerne l'immunité aux champs magnétiques extérieurs (champs parasite, courant de retour), mais le mode dégradé offre une solution de secours temporaire acceptable jusqu'à la prochaine intervention de maintenance.

Le système est particulièrement adapté à la mesure de courant triphasé de forte valeur, par exemple de l'ordre de grandeur de quelques milliers d'Ampères (1000A à 2000A ou plus), tout en utilisant des dispositifs de mesure de type « Boucle ouverte ».

Les avantages sont :

- Technologie boucle ouverte à faible coût
- Mesure de courant supérieur à 1000A sans saturation des circuits magnétiques
- Construction mécanique compacte
- Mesure des trois phases de courant avec seulement deux dispositifs de mesure magnétique
- Insensible aux champs magnétiques externe uniforme
- Insensible aux courants de retour circulant dans le plan des trois phases de courant.

La Fig. 4a montre l'influence d'un champ magnétique externe sur le capteur. Le champ magnétique externe He produit un signal positif sur la cellule B et positif sur la cellule A. On a donc la relation:

$$S(He) = k * (B-A) = 0.$$

Ce dispositif est donc protégé des champs uniformes extérieurs.

La Fig. 4b illustre l'influence des courants de retour. Ir est le courant de retour et Hr est le champ produit par Ir. Le champ Hi produit un signal positif sur la cellule B et négatif sur la cellule A. On a donc la relation:

$$S(Ip) = k * (B-A).$$

Le champ Hr produit un signal positif sur la cellule B et positif sur la cellule A.

$$S(Ip) = k * (B-A) = 0$$

On a donc la relation:

$$S = S(Ip) + S(Hr) = k * (B-A).$$

Le capteur selon l'invention est donc mieux protégé des champs extérieurs que les dispositifs à simple entrefer.

La Fig. 4c illustre l'influence des courants de retour perpendiculaire à l'axe des entrefers. Comme dans le cas précédent, le champ Hr n'a pas d'influence sur le signal S :

$$S = S(Ip)$$

Ce dispositif produit un niveau d'induction important dans le circuit magnétique. Le champ Hr, concentré par le circuit magnétique, vient s'additionner au champ Hi. La saturation du circuit magnétique peut être atteinte, produisant une non-linéarité du système de mesure. Le positionnement d'un retour de courant selon la configuration de la Fig. 4c est donc moins favorable que les autres configurations discutées précédemment.

**Revendications**

1. Capteur de courant triphasé pour la mesure de courants ($I_{PH}1$, $Ip_H2$, $Ip_H3$) circulant dans un système de conduction à trois phases (Ph1, Ph2, Ph3,), comprenant un premier dispositif de mesure magnétique (D1) et un deuxième dispositif de mesure magnétique (D3), chaque dispositif de mesure magnétique comprenant un circuit magnétique (M) comprenant au moins deux entrefers (E1, E2; E3, E4), et un détecteur de champ magnétique (C1, C2, C3, C4) disposé dans chaque entrefer du circuit magnétique, les dispositifs de mesure magnétique étant disposés de part et d'autre d'une partie de conducteur central, ou d'une cavité (7b) pour l'insertion d'un conducteur central formant l'une des trois phases du système de conduction.

2. Capteur selon la revendication 1, **caractérisé en ce que** lesdits au moins deux entrefers de chaque circuit magnétique des dispositifs de mesure magnétique sont disposés essentiellement dans un même plan (A).

3. Capteur selon la revendication précédente, **caractérisé en ce que** des axes de trois parties de conducteur traversant le capteur, ou des axes des trois cavités pour l'insertion des trois conducteurs, sont essentiellement parallèles et disposés dans ledit plan (A) des entrefers.

4. Capteur selon l'une des revendications précédentes, **caractérisé en ce que** les détecteurs de champ magnétique disposés dans les entrefers sont des capteurs à effet Hall.

5. Capteur selon l'une des revendications précédentes, **caractérisé en ce que** il y a deux circuits magnétiques et deux entrefers dans chaque circuit magnétique, les deux circuits magnétiques étant disposés de part et d'autre d'un conducteur d'une des phases ou d'une cavité pour l'insertion d'un conducteur d'une des phases n'ayant aucun dispositif de mesure magnétique.

6. Capteur selon l'une des revendications précédentes, **caractérisé en ce que** les dispositifs de mesure magnétique (D1, D3) sont montés sur une plaque de support (5) commune.

7. Capteur selon la revendication précédente, **caractérisé en ce que** la plaque de support constitue une paroi formant partie d'un boîtier (4) du capteur dans lequel les circuits magnétiques sont montés.

8. Capteur selon la revendication 6, **caractérisé en ce que** la plaque de support comprend un circuit avec une électronique pour le traitement des signaux.

9. Procédé de mesure de courants ($I_{PH}1$, $I_{PH}2$, $I_{PH}3$) circulant dans un système de conduction à trois phases (Ph1, Ph2, Ph3) au moyen d'un capteur de courant comprenant un premier dispositif de mesure magnétique (D1) et un deuxième dispositif de mesure magnétique (D3), chaque dispositif de mesure magnétique comprenant un circuit magnétique (M) entourant, respectivement, une desdites phases, le procédé comprenant :

   - la mesure du courant circulant dans une première des trois phases ($I_{PH}1$) à partir de la mesure du champ magnétique généré par ledit courant de cette première phase par le premier dispositif magnétique (D1),
   - la mesure du courant circulant dans une troisième des trois phases ($I_{PH}3$) à partir de la mesure du champ magnétique généré par ledit courant de cette troisième phase par le deuxième dispositif magnétique (D3), et
   - la mesure du courant d'une deuxième des trois phases ($I_{PH}2$) à partir de l'influence du champ magnétique généré par le courant de cette deuxième phase sur les premier et deuxième dispositifs magnétiques.

**10.** Procédé selon la revendication 9, **caractérisé en ce que** l'on utilise un capteur de courant selon l'une quelconque des revendications 1 à 8.

**Claims**

**1.** A three-phase current sensor for measuring currents ($I_{PH}1$, $Ip_H2$, $I_{PH}3$) flowing in a three-phase conduction system (Ph1, Ph2, Ph3), comprising a first magnetic measuring device (D1) and a second magnetic measuring device (D3), each magnetic measuring device comprising a magnetic circuit (M) comprising at least two magnetic circuit gaps (E1, E2; E3, E4), and a magnetic field detector (C1, C2, C3, C4) arranged in each magnetic circuit gap of the magnetic circuit, the magnetic measuring devices being arranged on either side of either a central conductor or a cavity (7b) for insertion of a central conductor forming one of the three phases of the conduction system.

**2.** The sensor as claimed in Claim 1, **characterised in that** said at least two magnetic circuit gaps of each magnetic circuit of the magnetic measuring devices are arranged essentially in the same plane (A).

**3.** The sensor as claimed in the preceding claim, **characterised in that** axes of three conductor portions passing through the sensor, or axes of the three cavities for insertion of the three conductors, are essentially parallel and arranged in said plane (A) of the magnetic circuit gaps.

**4.** The sensor as claimed in any one of the preceding claims, **characterised in that** the magnetic field detectors arranged in the magnetic circuit gaps are Hall sensors.

**5.** The sensor as claimed in any one of the preceding claims, **characterised in that** there are two magnetic circuits and two magnetic circuit gaps in each magnetic circuit, the two magnetic circuits being arranged on either side of a conductor of one of the phases or cavity for insertion of a conductor of one of the phases having no magnetic measuring device.

**6.** The sensor as claimed in any one of the preceding claims, **characterised in that** the magnetic measuring devices (D1, D3) are mounted on a common support plate (5).

**7.** The sensor as claimed in the preceding claim, **characterised in that** the support plate constitutes a wall forming part of a housing (4) of the sensor in which the magnetic circuits are mounted.

**8.** The sensor as claimed in Claim 6, **characterised in that** the support plate comprises a circuit with electronics for signal processing.

**9.** A process for measuring currents $I_{PH}1$, $I_{PH}2$, $I_{PH}3$) flowing in a three-phase conduction system (Ph1, Ph2, Ph3) by means of a current sensor comprising a first magnetic measuring device (D1) and a second magnetic measuring device (D3), each magnetic measuring device comprising a magnetic circuit (M) enclosing, respectively, one of said phases, the process comprising:

- measuring the current flowing in a first of the three phases ($I_{PH}1$) from the measurement of the magnetic field generated by said current of this first phase by the first magnetic device (D1),
- measuring the current flowing in a third of the three phases ($I_{PH}3$) from the measurement of the magnetic field generated by said current of this third phase by the second magnetic device (D3), and
- measuring the current of a second of the three phases ($I_{PH}2$) from the influence of the magnetic field generated by the current of this second phase on the first and second magnetic devices.

**10.** The process as claimed in Claim 9, **characterised in that** a current sensor is used as claimed in any one of Claims 1 to 8.

**Patentansprüche**

**1.** Drehstromsensor zum Messen von in einem Dreiphasen-Leitungssystem (Ph1, Ph2, Ph3) fließenden Strömen ($I_{PH}1$, $I_{PH}2$, $I_{PH}3$), eine erste Magnetmessvorrichtung (D1) und eine zweite Magnetmessvorrichtung (D3) umfassend, wobei jede Magnetessvorrichtung einen Magnetkreis (M) umfasst, der mindestens zwei Magnetkreisspalte (E1, E2;

E3, E4) umfasst, und einen Magnetfelddetektor (C1, C2, C3, C4), der in jedem Magnetkreisspalt des Magnetkreises angeordnet ist, wobei die Magnetmessvorrichtungen auf der einen und der anderen Seite eines Abschnitts des zentralen Leiters oder eines Hohlraums (7b) zur Aufnahme eines zentralen Leiters, der eine der drei Phasen des Leitungssystems bildet, angeordnet sind.

2. Sensor nach Anspruch 1, **dadurch gekennzeichnet, dass** die mindestens zwei Magnetkreisspalte jedes Magnetkreises der Magnetmessvorrichtungen im Wesentlichen auf ein und derselben Ebene (A) angeordnet sind.

3. Sensor nach vorangehendem Anspruch, **dadurch gekennzeichnet, dass** Achsen von drei den Sensor durchquerenden Leitungsabschnitten oder Achsen der drei Hohlräume zur Aufnahmen der drei Leiter im Wesentlichen parallel und in der Ebene (A) der Magnetkreisspalte angeordnet sind.

4. Sensor nach einem der vorangehenden Ansprüche, **dadurch gekennzeichnet, dass** die in den Magnetkreisspalten angeordneten Magnetfelddetektoren Hall-Sensoren sind.

5. Sensor nach einem der vorangehenden Ansprüche, **dadurch gekennzeichnet, dass** es in jedem Magnetkreis zwei Magnetkreise und zwei Magnetkreisspalte gibt, wobei die zwei Magnetkreise auf der einen und der anderen Seite eines Leiters einer der Phasen oder eines Hohlraums zur Aufnahme eines Leiters einer der Phasen ohne Magnetmessvorrichtung angeordnet sind.

6. Sensor nach einem der vorangehenden Ansprüche, **dadurch gekennzeichnet, dass** die Magnetmessvorrichtungen (D1, D3) auf einer gemeinsamen Trägerplatte (5) montiert sind.

7. Sensor nach vorangehendem Anspruch, **dadurch gekennzeichnet, dass** die Trägerplatte eine Wand darstellt, die Abschnitt eines Gehäuses (4) des Sensors ist, in dem die Magnetkreise montiert sind.

8. Sensor nach Anspruch 6, **dadurch gekennzeichnet, dass** die Trägerplatte einen Kreis mit einer Elektronik zur Signalverarbeitung umfasst.

9. Verfahren zur Messung von in einem Leitungssystem mit drei Phasen (Ph1, Ph2,Ph3) fließenden Strömen ($I_{PH}1$, $I_{PH}2$, $I_{PH}3$) mit einem Stromsensor, eine erste Magnetmessvorrichtung (D1) und eine zweite Magnetmessvorrichtung (D3) umfassend, wobei jede Magnetmessvorrichtung einen Magnetkreis (M) umfasst, der jeweils eine der Phasen umgibt, wobei das Verfahren umfasst:

- das Messen des in einer ersten der drei Phasen ($I_{PH}1$) fließenden Stroms ausgehend von der Messung des vom Strom dieser ersten Phase von der ersten Magnetvorrichtung (D1) erzeugten Magnetfelds,
- das Messen des in einer dritten der drei Phasen ($I_{PH}3$) fließenden Stroms ausgehend von der Messung des vom Strom dieser dritten Phase von der zweiten Magnetvorrichtung (D1) erzeugten Magnetfelds, und
- das Messen des Stroms einer zweiten der drei Phasen ($I_{PH}2$) ausgehend vom Einfluss des vom Strom dieser zweiten Phase auf die ersten und zweiten Magnetvorrichtungen erzeugten Magnetfelds.

10. Verfahren nach Anspruch 9, **dadurch gekennzeichnet, dass** ein Stromsensor nach einem der Ansprüche 1 bis 8 verwendet wird.

Fig. 1a

Fig. 1b

9c

9b

9a

4

**Fig. 2a**

1

6

A

9c

**Fig. 2b**

9b

5

4

9a

**Fig. 2c**

M3
9c
C4
9b
C2
9a
M1
C3
M4
M
C1
5
M2
M

**Fig. 3**

Dispositif 1          Dispositif 2          Dispositif 3

M1          H2          M3
A          H1                    H3
C1          $I_{PH}1$          $I_{PH}2$          $I_{PH}3$          C4
E1          C2          Ph2          C3          E4
E2          E3
M2          Ph1          M4
M                              M
D1          L1          L3          D3
1          Ph3

EP 1 913 406 B1

Fig. 4a

Fig. 4b

Fig. 4c

16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9427157 A

- GB 825137 A